# FASCICULE DE BREVET EUROPEEN

(11) **EP 2 015 349 B1**
(45) Date de publication et mention de la délivrance du brevet: **10.04.2013**
(21) Numéro de dépôt: 08159811.2
(22) Date de dépôt: 07.07.2008
(51) Int. Cl.: H01L 21/02

(54) **Procédé de fabrication d'un substrat semiconducteur-sur-isolant pour la microélectronique et l'optoélectronique**
Verfahren zur Herstellung eines Halbleiter-Isolator-Schichtsystem-Substrats für die Mikroelektronik und Optoelektronik
Method of manufacturing a semiconductor-on-insulator substrate for microelectronics and optoelectronics

(30) Priorité: 11.07.2007 FR 0756418
(43) Date de publication de la demande: 14.01.2009
(73) Titulaire: Commissariat à l'Énergie Atomique et aux Énergies Alternatives, 75015 Paris (FR)
(72) Inventeur: Damlencourt, Jean-François, 38190 Laval (FR); Clavelier, Laurent, 38000 Grenoble (FR)
(74) Mandataire: Ilgart, Jean-Christophe

(56) Documents cités:
- US-A1- 2005 116 290
- US-A1- 2006 157 706

## Description

### DOMAINE TECHNIQUE

L'invention se rapporte à un procédé de fabrication d'un substrat semiconducteur-sur-isolant pour la microélectronique et l'optoélectronique.

### ÉTAT DE LA TECHNIQUE ANTÉRIEURE

Du fait du ratio des modalités volumiques entre électrons et trous dans le silicium (respectivement 1500 et 500 cm²/V/s), les caractéristiques électriques des transistors N-MOS et P-MOS présentent des dissymétries et les P-MOS sont beaucoup moins performants (en terme de courant débité et donc de vitesse) que les N-MOS. La co-intégration d'un N-MOS en silicium et d'un P-MOS en germanium sur un même substrat est un moyen d'améliorer les caractéristiques du P-MOS dans un circuit C-MOS mais aussi d'équilibrer les transistors N et P tant en termes de niveau de courant qu'en termes de constantes de temps et ceci sans perte de place. En effet, la mobilité volumique des trous dans le germanium est de l'ordre de 1900cm²/V/s et celle des électrons dans le silicium est voisine de 1500cm²/V/s ce qui permet de fabriquer des transistors N et P de même dimensions et ayant quasiment les mêmes caractéristiques électriques statiques et dynamiques.

Une des techniques permettant de réaliser ce type de co-intégration est l'enrichissement en germanium. Cette technique repose d'une part sur la miscibilité totale du germanium et du silicium (qui ont la même structure cristalline), d'autre part sur la différence d'affinité chimique entre le germanium et le silicium vis-à-vis de l'oxygène. On peut se référer à ce sujet à l'article « Ultra-thin body SiGe-on-Insulator p-MOSFETs with high mobility SiGe surface channels » de T. TEZUKA et al., EDL 2002, Vol. 50, N°5, pages 1328 à 1333, 2003.

On va expliquer le principe de l'enrichissement en germanium d'un substrat SOI, à titre d'exemple un substrat comportant en superposition un support en silicium, une couche enterrée d'oxyde de silicium et une couche mince de silicium. On fait croître par épitaxie une couche de SiGe sur la couche mince de silicium. On provoque l'oxydation de la structure obtenue. La couche mince de silicium et la couche de SiGe s'enrichissent en germanium au cours de l'oxydation et, si l'on poursuit ce procédé suffisamment longtemps, on obtient une couche de germanium pur sur la couche d'oxyde enterrée, la couche de germanium étant recouverte d'une couche d'oxyde de silicium.

Cependant, cette technique d'enrichissement a une limitation technologique car le paramètre de maille du silicium est 4% plus petit que celui du germanium (taille de la maille variant de manière quadratique en fonction du pourcentage de germanium dans le SiGe). Donc, lorsque l'on épitaxie la couche de SiGe sur la couche mince en silicium du substrat SOI, tant que l'épaisseur de la couche de SiGe est inférieure à l'épaisseur critique de relaxation plastique, la couche de SiGe est contrainte en compression. Au-delà de cette épaisseur, le SiGe commence à relaxer la contrainte emmagasinée par création de défauts structuraux (dislocations, fautes d'empilements ...). Si on désire réaliser l'enrichissement du germanium à partir d'un substrat exempt de défauts, l'épaisseur de la couche de SiGe est limitée par l'épaisseur critique de relaxation plastique. Cette limitation de l'épaisseur initiale de la couche de SiGe influence l'épaisseur de la couche de germanium finale. En effet, lors de l'étape d'enrichissement en germanium, il y a conservation totale de la quantité de germanium. Par exemple, si on provoque un enrichissement germanium d'une structure comprenant une couche de SiGe de 100nm avec une concentration en Ge de 10% sur un substrat SOI, on obtient finalement une couche de germanium pur de 10nm.

Il est donc possible d'obtenir, par la technique d'enrichissement en germanium standard, des couches de germanium-sur-isolant sans défauts structuraux.

Par ailleurs, pour les couches semiconductrices, on fait une distinction en microélectronique entre les couches contraintes et les couches relaxées. On appelle « couche contrainte » toute couche d'un matériau semiconducteur dont la structure cristallographique est contrainte en tension ou en compression lors d'une croissance cristalline, telle qu'une épitaxie, modifiant la maille cristalline dans la direction de croissance. A l'inverse, on appelle « couche relaxée » toute couche d'un matériau semiconducteur qui a une structure cristallographique non contrainte, c'est-à-dire qui présente un paramètre de maille identique au paramètre de maille cubique du matériau de la couche. Une telle contrainte peut procurer à un matériau semiconducteur des propriétés électriques intéressantes. Ainsi, par exemple, l'intérêt principal des couches de silicium contraint en tension consiste principalement en ce qu'elles présentent une mobilité de porteurs de charges (tels que des trous et des électrons) plus importante que celle habituellement trouvée dans des couches de silicium relaxé.

Les couches de silicium contraint peuvent à cette égard atteindre une mobilité des porteurs de charges 100% plus importante que celle présente au sein de couches de silicium relaxé.

On peut ainsi envisager une co-intégration de composants électroniques performants et de composants photoniques sur un même substrat semiconducteur-sur-isolant. Le problème est d'obtenir sur un tel substrat à la fois une couche mince de silicium contraint ou sSOI (de l'anglais « strained Silicon-On-Insulator ») pour y réaliser des transistors N-MOS, une couche mince de germanium contraint ou sGeOI (de l'anglais « strained Germanium-On-Insulator ») pour y réaliser des transistors P-MOS, et une couche épaisse de germanium destinée aux composants photoniques.

Si on dispose d'un substrat semiconducteur-sur-isolant comprenant des zones en sSOI contraint et des zones en sGeOI contraint, il faudrait donc épaissir une zone en sGeOI contraint pour obtenir une couche épaisse de germanium destinée à des composants photoniques. Cependant, on dépasserait dans ce cas l'épaisseur critique de relaxation plastique du germanium sur le sGeOI et des défauts structuraux seraient générés dans la couche de germanium. Ces défauts structuraux, par exemple des dislocations émergentes (défauts qui traversent l'épaisseur de la couche pour émerger en surface), sont très nuisibles pour la mobilité dans les composants électroniques et également pour la lumière dans les composants photoniques.

### EXPOSÉ DE L'INVENTION

La présente invention a été conçue pour remédier aux inconvénients de l'art antérieur. Elle permet la co-intégration de composants électroniques et photoniques sur un même substrat. Ceci permet d'obtenir les avantages suivants. La possibilité de réaliser ces composants sur un substrat semiconducteur-sur-isolant permet un parfait contrôle électrostatique des composants. Il est possible de réaliser des transistors N-MOS sur SOI et des transistors P-MOS sur GeOI. L'invention permet le maintien de contraintes mécaniques : contrainte en tension pour le N-MOS et contrainte en compression pour le P-MOS, ces contraintes induisant un gain substantiel de mobilité. L'invention rend possible la co-intégration de composants photoniques sur des couches épaisses de Ge de haute qualité cristalline.

Il est proposé, selon la présente invention, de réaliser une co-intégration Si et Ge en couche fine et Ge en couche épaisse à partir d'un substrat sSOI présentant des orientations particulières <110> ou <111>.

L'invention a donc pour objet un procédé de fabrication d'un substrat semiconducteur-sur-isolant pour la microélectronique et l'optoélectronique, comprenant les étapes suivantes :
- fourniture d'un substrat comprenant un support présentant une face en matériau diélectrique supportant une couche mince de silicium contraint d'orientation <110> ou <111>,
- formation d'un premier masque sur une partie de la couche mince de silicium contraint,
- épitaxie de Si₁₋ₓGeₓ sur la partie de la couche non masquée par le premier masque,
- oxydation à haute température, selon la technique d'enrichissement en germanium, jusqu'à obtenir une couche de germanium contraint reposant sur la face en matériau diélectrique du support, la couche de germanium contraint étant alors recouverte d'une couche d'oxyde de silicium,
- élimination du premier masque et de la couche d'oxyde de silicium révélant ainsi une couche mince semiconductrice comprenant ladite partie en silicium contraint et une partie restante en germanium contraint,
- formation d'un deuxième masque sur ladite couche mince semiconductrice révélée par l'étape précédente, le deuxième masque préservant une zone de la partie restante en germanium contraint et au moins une zone de la partie en silicium contraint, le deuxième masque révélant une zone restante en germanium contraint,
- épitaxie de germanium sur la zone restante en germanium contraint pour obtenir une couche épaisse de germanium,
- élimination du deuxième masque.

Lors de l'étape d'épitaxie de germanium, le germanium relaxe, mais le substrat ayant une orientation appropriée, les dislocations restent confinées à l'interface entre la couche épaisse de germanium et la face en matériau diélectrique du support. L'absence de dislocations fournit un matériau de bonne qualité pour les composants optoélectroniques, la présence de dislocations à ladite interface n'étant a priori pas gênante.

De préférence, le matériau diélectrique du support est un matériau choisi parmi SiO₂, Si₃N₄ et Al₂O₃.

L'étape de fourniture d'un substrat peut comprendre :
- la croissance par épitaxie d'une couche épaisse, c'est-à-dire relaxée, de SiGe sur un substrat initial en silicium d'orientation <110> ou <111>,
- la croissance par épitaxie, à partir de la couche épaisse de SiGe, de ladite couche mince de silicium contraint,
- la formation d'une couche d'oxyde de silicium sur ladite couche mince de silicium contraint,
- la fixation d'un substrat poignée sur la face libre de la couche d'oxyde de silicium,
- la séparation de la structure obtenue pour éliminer la partie de la structure comprenant le substrat initial et la couche épaisse de SiGe.

Dans ce cas, il peut être prévu, avant l'étape de fixation du substrat poignée, une étape d'implantation ionique (par exemple une implantation d'hydrogène, conformément au procédé Smartcut™) dans la couche épaisse de SiGe pour y constituer une couche fragilisée, l'étape de séparation comprenant alors une étape de clivage de la structure au niveau de la couche fragilisée et une étape de retrait du SiGe subsistant sur la couche mince de silicium contraint. L'étape de clivage peut comprendre un traitement thermique de la couche fragilisée. On obtient ainsi un substrat sSOI dont la membrane active est d'orientation <110> ou <111> suivant que le substrat initial est d'orientation <110> ou <111>.

Le premier masque peut comprendre une couche d'oxyde de silicium formée sur la couche mince de silicium contraint et recouverte d'une couche de nitrure de silicium.

Le deuxième masque peut comprendre une couche de nitrure de silicium formée sur ladite couche mince semiconductrice.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1F illustrent l'étape de fourniture d'un substrat comprenant un support présentant une face en matériau diélectrique supportant une couche mince de silicium contraint, selon un mode de mise en oeuvre de l'invention ;
- les figures 2A à 2F illustrent un procédé de fabrication d'un substrat semiconducteur-sur-isolant selon la présente invention ;
- la figure 3 représente un graphique de l'épaisseur critique de relaxation plastique pour une épitaxie d'un alliage de silicium et de germanium en fonction du pourcentage en germanium dans l'alliage et en fonction du substrat de dépôt.

### EXPOSÉ DÉTAILLÉ DE MODES DE RÉALISATION PARTICULIERS

Le procédé de fabrication selon l'invention comprend d'abord une étape de fourniture d'un substrat comprenant un support présentant une face en matériau diélectrique supportant une couche mince de silicium contraint d'orientation <110> ou <111>. Dans l'exemple qui suit, la couche mince de silicium contraint est d'orientation <111>.

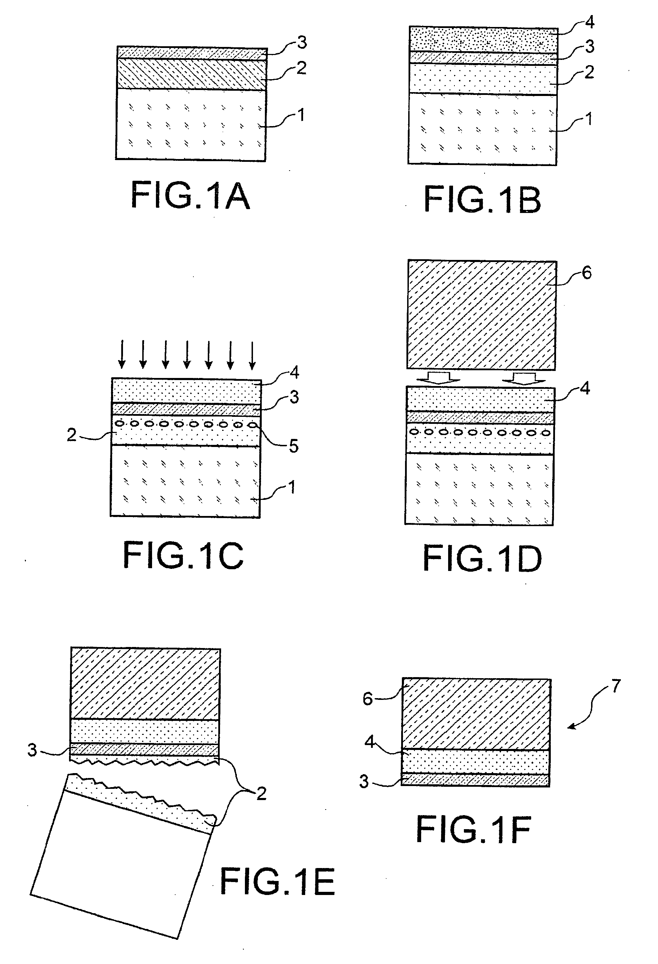

Les figures 1A à 1F illustrent une étape de fourniture d'un substrat comprenant un support présentant une face en matériau diélectrique supportant une couche mince de silicium contraint d'orientation <111>.

La figure 1A montre un substrat initial 1 en silicium d'orientation <111> supportant successivement une couche épaisse 2 de SiGe et une couche mince 3 de silicium contraint en tension.

La couche épaisse 2 est une couche relaxée obtenue par épitaxie. A titre d'exemple, son épaisseur est d'au moins 1 µm. Le dépôt de cette couche est réalisé sur une couche appelée substrat virtuel. Lors de la constitution de ce substrat virtuel, la concentration en Ge est augmentée progressivement, de manière linéaire ou par saut, jusqu'à obtenir la concentration désirée.

On dépose ensuite, toujours par épitaxie, la couche 3 de silicium, avec une épaisseur inférieure à l'épaisseur critique de relaxation des contraintes. A titre d'exemple, l'épaisseur de la couche 3 de silicium contraint peut être de quelques dizaines de nanomètres. La valeur de l'épaisseur critique de relaxation plastique de la couche de silicium dépend de la concentration en germanium de la couche épaisse de SiGe : par exemple Hc < 30 nm déposée sur une couche de Si_{0,7}Ge_{0,3}.

Son orientation reproduit l'orientation <111> du substrat 1. Si par exemple la couche de silicium est réalisée sur une face de la couche relaxée de SiGe de composition en Ge égale à 20%, la couche de Si aura un paramètre de maille de surface équivalent à celui d'un alliage de SiGe de 20%. On parlera alors d'un substrat sSOI <111> 20%.

Ensuite, on réalise une oxydation thermique de la couche de silicium contraint 3 pour obtenir une couche d'oxyde de silicium 4 (voir la figure 1B). La couche d'oxyde 4 peut aussi être obtenue par un dépôt LPCVD ou par une autre méthode. A titre d'exemple, l'épaisseur de la couche d'oxyde 4 est de 10 à 300 nm.

On procède ensuite à une étape d'implantation ionique conformément au procédé Smartcut™ divulgué notamment dans le document US 5 374 564. Les ions implantés sont par exemple des ions hydrogène. Les conditions d'implantation sont par exemple celles mentionnées dans le document FR-A-2 681 472 (correspondant au brevet US 5 374 564). Les flèches dessinées sur la figure 1C indiquent la direction d'implantation. On obtient une couche 5 de microcavités dans la couche 2 de SiGe.

La structure obtenue à l'issue de l'étape 1C est fixée sur un substrat poignée. La figure 1D montre un substrat poignée 6 en cours de fixation sur la face libre de la couche d'oxyde 4. La fixation peut être obtenue par collage moléculaire (ou « wafer bonding » en anglais). Le collage peut être amélioré par un traitement thermique, par exemple à une température de 600°C pendant 1 heure.

On procède ensuite au clivage de la couche de SiGe 3 au niveau de la couche de microcavités 5. Le clivage (voir la figure 1E) peut être obtenu au moyen d'un traitement thermique. On élimine ensuite la partie de la couche 2 de SiGe encore attachée à la couche mince 3 de Si contraint par exemple par gravure chimique dite HPA (HF/peroxygène/acide acétique) ou HNA (HF/acide nitrique/acide acétique).

On obtient alors la structure (ou substrat) 7 représentée à la figure 1F. Le substrat 7 comprend un support constitué par le substrat poignée 6 supportant successivement la couche d'oxyde 4 (ou couche enterrée) et la couche mince 3 de silicium contraint.

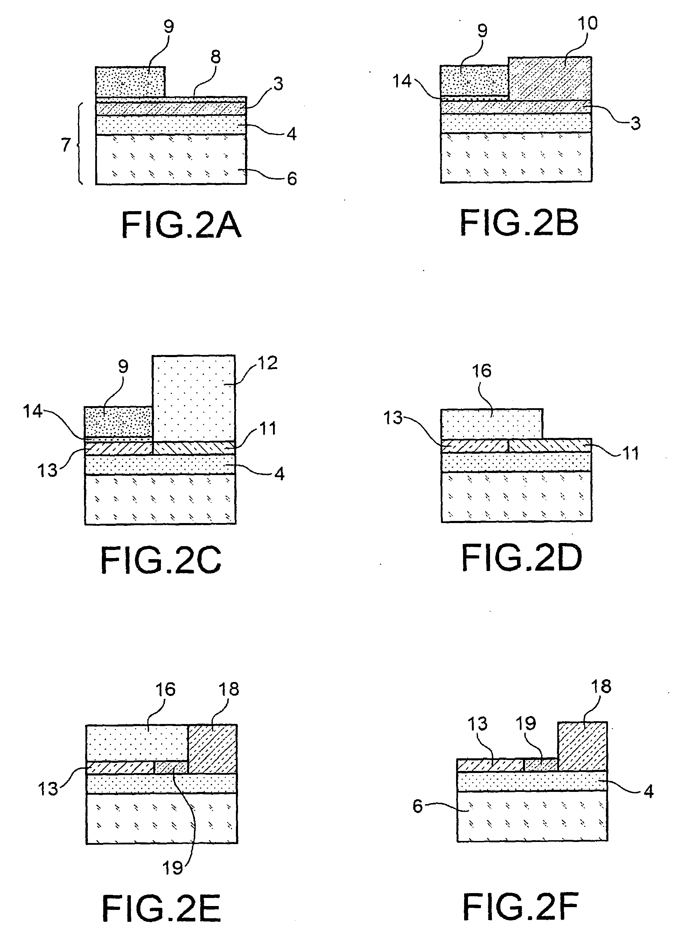

Les figures 2A à 2F illustrent un procédé de fabrication d'un substrat semiconducteur-sur-isolant selon la présente invention.

La figure 2A montre la structure 7 obtenue précédemment sur laquelle un premier masque est en cours de réalisation. Pour former ce premier masque, on forme d'abord une couche de protection 8 en oxyde de silicium, déposée par exemple par LPCVD et d'épaisseur comprise entre 3 et 20 nm, puis une couche de nitrure de silicium, déposée par exemple par LPCVD ou PECVD et d'épaisseur comprise entre 50 et 500 nm. On procède ensuite à une photolithographie de la couche de nitrure de silicium, puis à sa gravure pour obtenir le motif référencé 9 sur la figure 2A.

Le motif 9 en nitrure de silicium expose une partie de la couche 8 en oxyde de silicium. La partie exposée de la couche 8 est alors éliminée, par exemple par gravure humide (HF dilué), pour laisser subsister un motif 14 en oxyde de silicium.

On forme alors par épitaxie, à partir de la couche 3 de silicium contraint, une couche 10 de SiGe contraint en tension et d'orientation <111> comme la couche 3 (voir la figure 2B). Le pourcentage de contrainte de la couche 10 dépend du paramètre de maille de surface de la couche 3 de silicium contraint et de la composition de la couche 10 de SiGe. On peut, par exemple, déposer une couche 10 de Si_{0,9}Ge_{0,1} sur un substrat 7 de type sSOI 20% (paramètre de maille de surface équivalent à celui d'un alliage de Si_{0,8}Ge_{0,2}). La contrainte équivalente en tension sera alors équivalente à un désaccord de paramètre de maille de 0,4%.

On procède ensuite à une oxydation à haute température, selon la technique d'enrichissement en germanium, jusqu'à obtenir une couche 11 de germanium contraint reposant sur la couche d'oxyde enterrée 4. La couche 11 de germanium contraint est alors recouverte d'une couche 12 d'oxyde de silicium (voir la figure 2C). Au cours de cet enrichissement en germanium, la couche 10 de Si₁₋ₓGeₓ passe d'une contrainte en tension à une contrainte en compression. A noter que pour x égal au pourcentage de contrainte du sSOI de départ, alors la couche de Si₁₋ₓGeₓ n'a pas de contrainte mécanique.

On aboutit finalement à un substrat mixte comprenant, sur la couche d'oxyde enterrée 4, une couche 13 de silicium contraint en tension <111> jouxtant une couche 11 de germanium contraint en compression <111>. Les couches 11 et 13 sont appropriées à la réalisation de transistors CMOS : transistors N-MOS sur la couche 13 en silicium contraint et P-MOS sur la couche 11 en germanium contraint.

Afin d'intégrer sur le même substrat une couche de Ge adaptée à la réalisation de composants photoniques, il est nécessaire d'effectuer une reprise d'épitaxie de germanium sur une partie de la couche 11 de germanium contraint.

On procède alors au retrait du motif 9 en nitrure de silicium et du motif 14 en oxyde de silicium par exemple au moyen d'une gravure humide : H₃PO₄ pour le nitrure et HF pour l'oxyde.

Après avoir retiré le premier masque, on procède à la formation du deuxième masque. Pour cela, on forme une couche de nitrure de silicium, par exemple de 50 nm d'épaisseur. On procède ensuite à une photolithographie de la couche de nitrure de silicium, puis à sa gravure pour obtenir le motif référencé 16 sur la figure 2D. Le motif 16 en nitrure de silicium expose une partie de la couche 11 de germanium contraint.

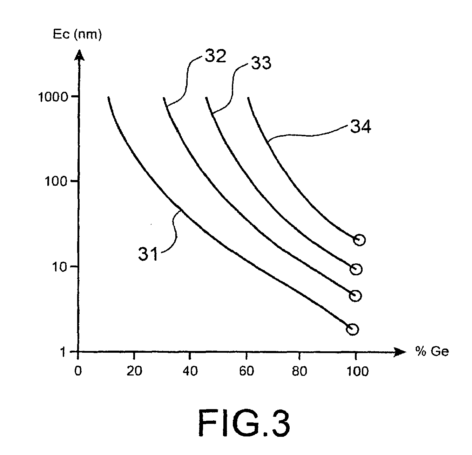

On forme alors par épitaxie (voir la figure 2E) une couche 18 de germanium à partir de la zone exposée de la couche 11 de germanium contraint, la couche 18 englobant la couche 11. Dans ce cas, les contraintes mécaniques ne sont plus maintenues. On dépasse l'épaisseur critique Ec de relaxation plastique donnée par la figure 3 qui sera décrite plus loin (cette épaisseur critique est signalée par des cercles sur la figure 3) en fonction de la contrainte initiale liée au sSOI <111> de départ et exprimée en fonction du paramètre de maille de surface équivalent à un alliage SiGe de x%. On génère alors des défauts structuraux dans la couche 18. Cependant, en utilisant un substrat désorienté <111>, les défauts sont confinés dans le plan d'interface <111> situé entre la couche 18 de germanium et la couche d'oxyde enterrée 4 et n'affectent en rien les propriétés optiques de la couche résultante.

En raison des contraintes technologiques (épaisseur de la couche de GeOI contrainte), l'épitaxie est réalisée à basse température (par exemple autour de 400°C) et l'épaisseur finale de la couche épaisse de germanium (pour composants photoniques) est de l'ordre de quelques centaines de nm, idéalement 400 nm.

La formation de la couche de germanium 18 laisse subsister une couche de germanium contraint 19 destinée à la fabrication de transistors MOS. La couche 19 a une épaisseur inférieure de 70 nm.

La figure 2F montre la structure finalement obtenue et formée d'un support 6 en silicium supportant une couche d'oxyde enterrée 4 et une couche semiconductrice-sur-isolant constituée de parties adjacentes : une couche mince 13 de silicium contraint, une couche mince 19 de germanium contraint et une couche épaisse relaxée 18 de germanium.

La figure 3 représente un graphique de l'épaisseur critique de relaxation plastique pour une épitaxie d'un alliage de silicium et de germanium en fonction du pourcentage en germanium dans l'alliage et en fonction du substrat de départ.

Sur la figure 3, la courbe 31 représente la courbe d'épaisseur critique de Si₁₋ₓGeₓ sur du silicium non contraint sur isolant (SOI), la courbe 32 représente la courbe d'épaisseur critique de Si₁₋ₓGeₓ sur du silicium contraint sSOI 20%, la courbe 33 représente la courbe d'épaisseur critique de Si₁₋ₓGeₓ sur du silicium contraint sSOI 35% et la courbe 34 représente la courbe d'épaisseur critique de Si₁₋ₓGeₓ sur du silicium contraint sSOI 50%.

L'invention permet donc de fournir des substrats comprenant une couche semiconductrice-sur-isolant comprenant une zone sSOI <111> pour la réalisation de transistors N-MOS, une zone sGeOI fine <111> pour la réalisation de transistors P-MOS et une zone GeOl épaisse <111> pour la réalisation de photodétecteurs.

La reprise d'épitaxie effectuée sur la zone sGeOI et dédiée à la photodétection peut être une reprise d'épitaxie de Ge pur ou une alternance de dépôts de Ge dopé n, p ou non intentionnellement dopé (nid) pour réaliser une structure PIN.

L'utilisation de surfaces <110> et <111> offre aussi d'autres avantages :
- amélioration des propriétés d'interface Ge/oxyde de haute constante diélectrique (oxyde de grille) lors de la réalisation de transistors,
- amélioration de propriétés de mobilité des porteurs (trous),
- confinement des dislocations dans le plan d'interface <111> lorsqu'on dépasse l'épaisseur critique de relaxation plastique.

## Revendications

1. Procédé de fabrication d'un substrat semiconducteur-sur-isolant pour la microélectronique et l'optoélectronique, comprenant les étapes suivantes :
- fourniture d'un substrat (7) comprenant un support (6) présentant une face en matériau diélectrique supportant une couche mince (3) de silicium contraint d'orientation <110> ou <111>,
- formation d'un premier masque (9, 14) sur une partie de la couche mince (3) de silicium contraint,
- épitaxie de Si₁₋ₓGeₓ (10) sur la partie de la couche non masquée par le premier masque,
- oxydation à haute température, selon la technique d'enrichissement en germanium, jusqu'à obtenir une couche de germanium contraint (11) reposant sur la face en matériau diélectrique du support, la couche de germanium contraint étant alors recouverte d'une couche d'oxyde de silicium (12),
- élimination du premier masque (9, 14) et de la couche d'oxyde de silicium (12) révélant ainsi une couche mince semiconductrice comprenant ladite partie en silicium contraint (13) et une partie restante en germanium contraint (11),
- formation d'un deuxième masque (16) sur ladite couche mince semiconductrice révélée par l'étape précédente, le deuxième masque préservant une zone de la partie restante en germanium contraint et au moins une zone de la partie en silicium contraint, le deuxième masque révélant une zone restante en germanium contraint,
- épitaxie de germanium sur la zone restante en germanium contraint pour obtenir une couche épaisse de germanium (18),
- élimination du deuxième masque (16).

2. Procédé selon la revendication 1, dans lequel le matériau diélectrique du support est un matériau choisi parmi SiO₂, Si₃N₄ et Al₂O₃.

3. Procédé selon l'une quelconque des revendications 1 ou 2, dans lequel l'étape de fourniture d'un substrat (7) comprend :
- la croissance par épitaxie d'une couche épaisse (2), c'est-à-dire relaxée, de SiGe sur un substrat initial (1) en silicium d'orientation <110>.et <111>,
- la croissance par épitaxie, à partir de la couche épaisse (2) de SiGe, de ladite couche mince de silicium contraint (3),
- la formation d'une couche d'oxyde de silicium (4) sur ladite couche mince de silicium contraint (3),
- la fixation d'un substrat poignée (6) sur la face libre de la couche d'oxyde de silicium (4),
- la séparation de la structure obtenue pour éliminer la partie de la structure comprenant le substrat initial (1) et la couche épaisse de SiGe (2).

4. Procédé selon la revendication 3, dans lequel il est prévu, avant l'étape de fixation du substrat poignée (6), une étape d'implantation ionique dans la couche épaisse de SiGe (2) pour y constituer une couche fragilisée (5), l'étape de séparation comprenant alors une étape de clivage de la structure au niveau de la couche fragilisée (5) et une étape de retrait du SiGe subsistant sur la couche mince de silicium contraint (3).

5. Procédé selon la revendication 4, dans lequel l'étape de clivage comprend un traitement thermique de la couche fragilisée (5).

6. Procédé selon l'une quelconque des revendications 1 à 5, dans lequel le premier masque comprend une couche d'oxyde de silicium (14) formée sur la couche mince de silicium contraint (3) et recouverte d'une couche de nitrure de silicium (9).

7. Procédé selon l'une quelconque des revendications 1 à 6, dans lequel le deuxième masque comprend une couche de nitrure de silicium (16).

## Claims

1. method for manufacturing a semiconductor-on-insulator substrate for microelectronics and optoelectronics, comprising the following steps :
- supplying a substrate (7) comprising a support (6) having one face made of a dielectric material supporting a strained silicon thin layer (3) having a <110> or <111> orientation,
- formation of a first mask (9, 14) on a portion of the strained silicon thin layer (3),
- epitaxy of Si₁₋ₓGeₓ (10) on the portion of the layer not masked by the first mask,
- high-temperature oxidation, according to the germanium condensation technique, until a strained germanium layer is obtained (11), which rests on the face of the support made of a dielectric material, the strained germanium layer then being covered by a silicon oxide layer (12),
- elimination of the first mask (9, 14) and of the silicon oxide layer (12), thereby exposing a semi-conducting thin layer comprising said strained silicon portion (13) and a remaining strained germanium portion (11),
- formation of a second mask (16) on said semi-conducting thin layer exposed via the previous step, the second mask protecting a region of the remaining strained germanium portion and at least one region of the strained silicon portion, the second mask exposing a remaining strained germanium portion,
- epitaxial growth of germanium on the remaining strained germanium portion, in order to obtain a germanium thick layer (18),
- elimination of the second mask (16).

2. Method of claim 1, wherein the dielectric material of the support is a material chosen from SiO₂, Si₃N₄ and Al₂O₃.

3. Method as claimed in any of claims 1 or 2, wherein the step for supplying a substrate (7) includes :
- epitaxial growth of a thick, that is relaxed, SiGe layer (2) on a initial silicon substrate (1) having a <110> or <111> orientation,
- epitaxial growth of said strained silicon thin layer (3) from the SiGe thick layer (2),
- formation of a silicon oxide layer (4) on said strained silicon thin layer (3),
- bonding of a handle substrate (6) to the free face of the silicon oxide layer (4),
- separation of the resulting structure in order to eliminate the portion of the structure comprising the initial substrate (1) and the SiGe thick layer (2).

4. Method of claim 3, wherein provisions are made for an ion implantation step, prior to the handle substrate (6) bonding step, in the SiGe thick layer (2), in order to produce an embrittled layer (5) therein, the separation step then comprising a step for cleaving the structure in the area of the embrittled layer (5) and a step for removing the SiGe remaining on the strained silicon thin layer (3).

5. Method of claim 4, wherein the cleaving step includes a heat treatment of the embrittled layer (5).

6. Method as claimed in any of claims 1 to 5, wherein the first mask includes a silicon oxide layer (14) formed on the strained silicon thin layer (3) and covered with a silicon nitride layer (9).

7. Method as claimed in any of claims 1 to 6, wherein the second mask includes a silicon nitride layer (16).

## Patentansprüche

1. Fabrikationsverfahren eines Halbleiter-Isolator-Schichtsystem-Substrats für die Mikroelektronik und die Optoelektronik, die folgenden Schritte umfassend:
- Herstellung eines Substrats (7), umfassend einen Träger (6) mit einer Fläche aus dielektrischen Material, die eine dünne Schicht (3) aus gedehntem (strained) Silizium der Orientierung <110> oder <111> trägt,
- Ausbildung einer ersten Maske (9, 14) auf einem Teil der dünnen Schicht (3) aus gedehntem Silizium,
- Epitaxie von Si₁₋ₓGeₓ (10) auf dem durch die erste Maske nicht maskierten Teil,
- Hochtemperaturoxidation gemäß der Germaniumanreicherungstechnik, bis man eine auf der Fläche aus dielektrischem Material des Trägers ruhende gedehnte Germaniumschicht (11) erhält, wobei die gedehnte Germaniumschicht dann mit einer Siliziumschicht (12) überzogen wird,
- Beseitigung der ersten Maske (9, 14) und der Siliziumoxidschicht (12), auf diese Weise eine - den genannten Teil aus gedehntem Silizium (13) und einen restlichen Teil aus gedehntem Germanium (11) umfassend - dünne Halbleiterschicht freilegend,
- Ausbildung einer zweiten Maske (16) auf der durch den vorhergehenden Schritt freigelegten dünnen Halbleiterschicht, wobei diese - eine Zone des restlichen Teils aus gedehntem Germanium und wenigstens eine Zone des Teils aus gedehntem Silizium schützende - zweite Maske eine restliche Zone aus gedehntem Germanium frei lässt,
- Germanium-Epitaxie in der restlichen Zone aus gedehntem Germanium, um eine dicke Germaniumschicht (18) zu erzeugen,
- Beseitigung der zweiten Maske (16).

2. Verfahren nach Anspruch 1, bei dem das dielektrische Material des Trägers ein unter SiO₂, Si₃N₄ und Al₂O₃ ausgewähltes Material ist.

3. Verfahren nach einem der Ansprüche 1 oder 2, bei dem der Schritt zur Herstellung eines Substrats (7) umfasst:
- das Aufwachsen einer dicken, das heißt entspannten SiGe-Epitaxieschicht (2) auf einem Anfangssubstrat (1) aus Silizium der Orientierung <110> und <111>,
- das Aufwachsen - auf der dicken SiGe-Schicht - der genannten dünnen Schicht aus gedehntem Silizium (3) durch Epitaxie,
- die Bildung einer Siliziumoxidschicht (4) auf der genannten dünnen Schicht aus gedehntem Silizium (3),
- die Befestigung eines Griffsubstrats (6) an der freien Fläche der Siliziumoxidschicht (4),
- die Durchtrennung der hergestellten Struktur, um den das Anfangssubstrat (1) und die dicke SiGe-Schicht (2) umfassenden Teil der Struktur zu beseitigen.

4. Verfahren nach Anspruch 3, bei dem vor dem Schritt zur Befestigung eines Griffsubstrats (6) ein Schritt zur Ionenimplantation in der dicken SiGe-Schicht (2) vorgesehen ist, um eine Bruchschicht (5) herzustellen, wobei der Durchtrennungsschritt dann einen Schritt zum Spalten der Struktur in Höhe der Bruchschicht (5) und einen Schritt zum Entfernen des restlichen SiGe auf der dünnen Schicht aus gedehntem Silizium (3) umfasst.

5. Verfahren nach Anspruch 4, bei dem der Spaltungsschritt eine thermische Behandlung der Bruchschicht (5) umfasst.

6. Verfahren nach einem der Ansprüche 1 bis 5, bei dem die erste Maske eine Siliziumoxidschicht (14) umfasst, die auf der dünnen Schicht aus gedehntem Silicium (3) ausgebildet und mit einer Siliziumnitridschicht (9) überzogen ist.

7. Verfahren nach einem der Ansprüche 1 bis 6, bei dem die zweite Maske eine Siliziumnitridschicht (16) umfasst.
